# FASCICULE DE BREVET EUROPEEN

(11) **EP 1 500 146 B1**
(45) Date de publication et mention de la délivrance du brevet: **01.10.2014**
(21) Numéro de dépôt: 03747464.0
(22) Date de dépôt: 23.04.2003
(51) Int. Cl.: H01L 31/032, H01L 31/18

(54) **PROCEDE DE FABRICATION DE SEMI-CONDUCTEURS EN COUCHES MINCES A BASE DE COMPOSES I-III-VI(2), POUR APPLICATIONS PHOTOVOLTAIQUES**
VERFAHREN ZUR HERSTELLUNG VON DÜNNFILMHALBLEITERN AUF DER BASIS VON I-III-VI(2)-VERBINDUNGEN FÜR PHOTOVOLTAIKANWENDUNGEN
METHOD FOR MAKING THIN-FILM SEMICONDUCTORS BASED ON I-III-VI(2) COMPOUNDS, FOR PHOTOVOLTAIC APPLICATIONS

(30) Priorité: 29.04.2002 FR 0205362
(43) Date de publication de la demande: 26.01.2005
(73) Titulaire: Electricité de France, 75008 Paris (FR); CENTRE NATIONAL DE LA RECHERCHE SCIENTIFIQUE (CNRS), 75794 Paris Cedex 16 (FR)
(72) Inventeur: TAUNIER, Stéphane, F-75012 Paris (FR); KERREC, Olivier, F-92500 Rueil Malmaison (FR); MAHE, Michel, F-77670 Saint-Mammes (FR); GUIMARD, Denis, F-75013 Paris (FR); BEN-FARAH, Moëz, F-77210 Avon (FR); LINCOT, Daniel, F-92160 Antony (FR); GUILLEMOLES, Jean-François, F-75013 Paris (FR); GRAND, Pierre, Philippe, F-92500 Rueil-Malmaison (FR); COWACHE, Pierre, F-77290 Mitry-Mory (FR); VEDEL, Jacques, F-92600 Asnières-sur-Seine (FR)
(74) Mandataire: Cabinet Plasseraud
(86) Numéro de dépôt international: PCT/FR2003/001282
(87) Numéro de publication internationale: WO 2003/094246

(56) Documents cités:
- DE-A- 19 917 758
- US-A- 5 578 503
- GUILLEN C ET AL: "CATHODIC ELECTRODEPOSITION OF CUINSE2 THIN FILMS" THIN SOLID FILMS, ELSEVIER-SEQUOIA S.A. LAUSANNE, CH, vol. 195, no. 1 / 2, 1991, pages 137-146, XP000177084 ISSN: 0040-6090
- TZVETKOVA E ET AL: "Preparation and structure of annealed CuInSe2 electrodeposited films" THIN SOLID FILMS, ELSEVIER-SEQUOIA S.A. LAUSANNE, CH, vol. 311, no. 1-2, 31 décembre 1997 (1997-12-31), pages 101-106, XP004121326 ISSN: 0040-6090
- CHOWLES A G ET AL: "Deposition and characterization of CuInSe2" RENEWABLE ENERGY, PERGAMON PRESS, OXFORD, GB, vol. 6, no. 5, 9 juillet 1995 (1995-07-09), pages 613-618, XP004049008 ISSN: 0960-1481
- GUILLEN C ET AL: "Recrystallization and components redistribution processes in electrodeposited CuInSe2 thin films" THIN SOLID FILMS, ELSEVIER-SEQUOIA S.A. LAUSANNE, CH, vol. 387, no. 1-2, 29 mai 2001 (2001-05-29), pages 57-59, XP004232911 ISSN: 0040-6090
- PERN F J ET AL: "CHARACTERIZATIONS OF ELECTRODEPOSITED CUINSE2 THIN FILMS: STRUCTURE, DEPOSITION AND FORMATION MECHANISMS" THIN SOLID FILMS, ELSEVIER-SEQUOIA S.A. LAUSANNE, CH, vol. 202, no. 2, 30 juillet 1991 (1991-07-30), pages 299-314, XP000232771 ISSN: 0040-6090
- YAMAMOTO A ET AL: "Composition control of electrodeposited Cu-In-Se layers for thin film CuInSe2 preparation" SOLAR ENERGY MATERIALS AND SOLAR CELLS, ELSEVIER SCIENCE PUBLISHERS, AMSTERDAM, NL, vol. 50, no. 1-4, 1998, pages 25-30, XP004102487 ISSN: 0927-0248
- CALIXTO M E ET AL: "Compositional and optoelectronic properties of CIS and CIGS thin films formed by electrodeposition" SOLAR ENERGY MATERIALS AND SOLAR CELLS, ELSEVIER SCIENCE PUBLISHERS, AMSTERDAM, NL, vol. 59, no. 1-2, septembre 1999 (1999-09), pages 75-84, XP004181618 ISSN: 0927-0248

## Description

La présente invention concerne le domaine des dépôts de couches minces de semi-conducteurs pour des applications photovoltaïques.

Des couches minces de diséléniure et/ou disulfure de cuivre et d'indium et/ou de gallium (CIGS) sont déposées sur substrat pour fabriquer des cellules photovoltaïques. De tels composés, de formule générale CuGaₓIn₁₋ₓSe_{2-y}S_{y} (avec x compris entre 0 et 1 et y compris entre 0 et 2), sont considérés comme très prometteurs et pourraient constituer la prochaine génération de cellules solaires en couches minces. Les matériaux semi-conducteurs CIGS ont une largeur de bande interdite ("*gap*" direct) compris entre 1,0 et 1,6 eV qui permet une forte absorption des radiations scolaires dans le visible. Des rendements de conversion records, supérieurs à. 18%, ont été obtenus récemment sur des cellules de petites surfaces.

Les composés CIGS sont aussi dénommés I-III-VI₂, en référence à la nature chimique de leurs constituants, où :
- l'élément Cu représente un élément de la colonne I (colonne 1B de la table de classification de Mendeleïev),
- l'élément In et/ou l'élément Ga représentent des éléments de la colonne III (colonne 3B de la table de classification de Mendeleiev), et
- l'élément Se et/ou l'élément S représentent un élément de la colonne VI (colonne 6B de la table de classification de Mendeleïev).

On compte donc approximativement deux atomes de la colonne VI pour un atome de la colonne I et un atome de la colonne III, dans le domaine 'monophasé autour de la composition I-III-VI₂ du CIGS.

Les couches de CIGS utilisées pour la conversion photovoltaïque doivent présenter un caractère semi-conducteur de type p et de bonnes propriétés de transport de charge. Ces propriétés de transport de charge sont favorisées par une bonne cristallinité. Ainsi, les composés CIGS doivent être au moins partiellement cristallisés pour posséder des propriétés photovoltaïques suffisantes pour leur application à la fabrication de cellules solaires. Les composés CIGS cristallisés ont une structure cristallographique correspondant au système des chalcopyrites ou des sphalérites, suivant la température de dépôt.

Les couches minces de CIGS, lorsqu'elles sont déposées à basse température (dépôt de précurseur), sont faiblement cristallisées, voire amorphes, et un recuit des couches par apport thermique doit être réalisé pour obtenir une amélioration de la cristallisation du CIGS et des propriétés de transport de charge satisfaisantes.

Néanmoins, aux températures permettant une cristallisation au moins partielle du CIGS, l'un des éléments constitutifs du CIGS (en principe le sélénium Se) est plus volatil que les autres éléments. Il est donc difficile d'obtenir du CIGS cristallisé avec la composition souhaitée (proche de la stoechiométrie I-III-VI₂) sans rajouter du sélénium pour le recuit de la couche de précurseur.

De plus, pour obtenir un caractère semi-conducteur de type p (conduction par trous), la composition des couches doit présenter un léger écart à la stoechiométrie I-III-VI₂, en faveur de l'élément VI.

C'est ainsi que dans la fabrication de couches minces de CIGS pour des applications photovoltaïques, 'les réalisations de l'art antérieur utilisent un recuit des dépôts précurseurs en présence d'un excès de sélénium en phase vapeur.

Les meilleurs rendements de conversion photovoltaïque à partir de CIGS (supérieurs à 17%) ont été obtenus en préparant des couches minces par évaporation. Cependant, l'évaporation est une technique coûteuse et difficile à mettre en oeuvre à l'échelle industrielle notamment en raison de problèmes de non-uniformité des dépôts de couches minces sur de grandes surfaces et d'un faible rendement de l'utilisation des matières premières.

La pulvérisation cathodique (ou "*sputtering*") est mieux adaptée aux grandes surfaces mais elle nécessite des équipements de vide et des cibles de précurseurs très coûteux. On entend par *"précurseurs"* des composés intermédiaires dont les propriétés physico-chimiques sont distinctes de celles de CIS (ou de CIGS) et les rendent inaptes à la conversion photovoltaïques. Ils sont déposés initialement sous forme de couche mince, cette couche mince étant ensuite traitée pour former le dépôt souhaité de CIGS.

Le dépôt par électrochimie offre une alternative avantageuse. Cependant, les difficultés rencontrées portent sur le contrôle de la qualité des précurseurs électrodéposés (composition, morphologie) et leur traitement en vue de conférer des propriétés électroniques adéquates pour la conversion photovoltaïque. Plusieurs approches ont été proposées pour surmonter ces difficultés parmi lesquelles :
- l'électrodéposition séparée, ou séquentielle, des précurseurs Cu puis In, suivie d'un ajout de Se (étape dite de "*sélénisation*")*,* telle que décrite dans US-4 581 108 ;
- l'électrodéposition de binaires (Cu, In), en présence d'une suspension de Se, telle que décrite dans US-5 275 714.

Il est en effet plus facile d'apporter un seul précurseur à la fois.

Des développements plus récents (US-5 730 852, US-5 804 054) proposent une électrodéposition qui revient à déposer une couche de précurseurs de composition CuₓIn_{y}Ga_{z}Seₙ (avec x, y et z compris entre 0 et 2, et n compris entre 0 et 3), en utilisant une méthode par courants pulsés. L'électrodéposition est suivie d'une étape d'évaporation des éléments In, Ga et Se, afin d'accroître leur teneur par rapport à la couche électrolysée.

En ce qui concerne l'électrodéposition "*pure*", c'est-à-dire sans étape d'évaporation et à la stoechiométrie I-III-VI₂, les meilleurs rendements sont de 6 à 7% environ, comme l'indiquent les publications :
- GUILLEMOLES et al., Advanced Materials, 6 (1994) 379 ;
- GUILLEMOLES et al., J. Appl. Phys., 79 (1996) 7293.

Ces publications indiquent en outre que de meilleurs résultats sont obtenus lorsque des recuits sont effectués sous pression de vapeur de sélénium, à des températures supérieures à 450°C, sous vide. On applique alors un recuit conventionnel dans un four à diffusion, sous pression de Se élémentaire. Toutefois, de tels recuits sont relativement longs (de l'ordre d'une à quelques heures).

Le document DE 19917758 A1 décrit la fabrication d'une couche CIS à partir d'un dépôt ternaire par électrochimie. L'approvisionnement de sélénium dans le four à recuit est évité par un recuit à échauffement très rapide.

Le document US-5 578 503 décrit un procédé en deux étapes, qui prévoit d'abord un dépôt par pulvérisation cathodique (ou "*sputtering*")*,* puis un recuit rapide (à lampes) des précurseurs ainsi déposés. En particulier, des éléments précurseurs Cu, In et Se sont déposés séparément sous forme élémentaire (Cu(0), In(0) et Se(0)) ou sous forme de binaires (tels que In₂Se₃). Ainsi, la structure initialement déposée avant recuit est essentiellement hétérogène et se présente sous la forme d'une multiplicité de feuillets successifs (empilements de Cu⁰/In⁰/Se⁰ ou Cu⁰/In₂Se₃, ou encore une combinaison des deux) dans le sens de l'épaisseur de la couche. Ce mélange de précurseurs subit ensuite un recuit rapide, comprenant une montée en température suivie d'un pallier nécessaire pour homogénéiser la couche de CIS. Néanmoins, la couche mince déposée par pulvérisation et de structure hétérogène en feuillets supporte mal, notamment mécaniquement, des montées brusques eh température. Le coefficient de dilatation en température de la couche étant spatialement inhomogène, des problèmes de décollement de cette couche peuvent apparaître durant l'étape de recuit. Un tel procédé, bien qu'avantageux, n'est donc pas encore complètement satisfaisant.

Plus généralement, les procédés de dépôt par évaporation ou par pulvérisation *(sputtering)* utilisent des sources qui sont couramment constituées d'éléments purs, ou le cas échéant de binaires, mais rarement de ternaires. Une difficulté survient dans la mise en oeuvre de tels procédés. Elle consiste dans le transfert des éléments de la source vers le substrat. Ce transfert n'est pas le même pour tous les éléments et la vitesse d'évaporation ou le taux de pulvérisation peuvent être différents pour un élément par rapport à l'autre. En particulier, à haute température, les tensions de vapeur des éléments (leur volatilité) peuvent être très différentes. Cet effet est d'autant plus pénalisant que le nombre des éléments dans l'alliage à obtenir est grand

### (ternaire CIS, quaternaire CIGS, etc.)

La présente invention vient améliorer la situation.

Elle propose à cet effet un procédé de fabrication en couches minces d'alliages semi-conducteurs I-III-VI₂, pour des applications photovoltaïques, selon la revendication 1.

On entend par "*grains nanométriques*", des grains d'alliages qui, avantageusement, présentent majoritairement une nature physico-chimique proche de celle de l'alliage visé à l'étape b) (aussi bien en termes de composition que de liaisons entre atomes, notamment) et pouvant atteindre jusqu'à quelques dizaines de nanomètres.

L'ensemble des grains forme alors une matrice avantageusement compacte et capable de supporter une augmentation brusque en température pendant l'étape de recuit b).

Ainsi, la présente invention se manifeste globalement par l'association de deux étapes consistant en :
- la préparation d'un précurseur dont les éléments sont intimement liés, ce précurseur étant de morphologie capable de supporter le recuit rapide de l'étape b), et
- le recuit rapide de ce précurseur, tel que la cinétique du traitement soit suffisamment rapide pour limiter l'exodiffusion de l'élément VI (du fait de sa volatilité) pendant le recuit, tout en permettant une cristallisation satisfaisante de la couche.

De plus, comme indiqué ci-avant, la conservation de l'élément VI dans la couche après recuit confère un caractère semi-conducteur de type p, favorable à la conversion photovoltaïque.

Selon l'invention, tant pour une rapidité que pour une simplicité de mise en oeuvre industrielle, ladite couche mince est déposée à l'étape a) par électrochimie.

Dans une réalisation préférée, le recuit de l'étape b) s'effectue par éclairement, de préférence direct, à partir d'une source de lumière. En variante, le recuit s'effectue par induction.

Pour un recuit de CIS (ou CIGS) à l'étape b), la température de la couche est préférentiellement élevée à plus de 450°C.

Avantageusement, le recuit rapide de l'étape b) peut s'effectuer en transférant à la couche mince une densité de puissance d'éclairement de l'ordre de la dizaine de Watts par cm² et pendant des durées inférieures ou de l'ordre de la dizaine de secondes.

Le rendement photovoltaïque des couches minces obtenues après recuit peut être de l'ordre ou même supérieur à 8%, dans ces conditions.

D'autres caractéristiques et avantages de la présente invention apparaîtront à la lecture de la description détaillée ci-après et à l'examen des dessins annexés, sur lesquels :
- la figure 1 représente schématiquement une installation de dépôt, par électrochimie, d'une couche mince de CIS ;
- la figure 2 représente schématiquement l'aspect de la structure sous forme de matrice d'un précurseur avant recuit, à l'échelle nanométrique ;
- la figure 3 représente une installation de recuit rapide, par éclairage de la couche mince obtenue par électrodéposition ;
- la figure 4 représente schématiquement la structure, en couches minces, d'une cellule destinée à des applications photovoltaïques ;
- la figure 5 illustre, à titre d'exemple pour du CIS, des couples de durées (abscisses) et de densités moyennes de puissance d'éclairement (ordonnées) permettant de cristalliser au moins partiellement une couche sans la dégrader ;
- la figure 6 illustre, selon une autre représentation (ici en échelles logarithmiques), des couples de durées (abscisses) et d'énergies fournies à la couche (ordonnées) permettant de cristalliser au moins partiellement une couche de CIS sans la dégrader et d'obtenir les rendements photovoltaïques indiqués en-dessous des points expérimentaux à titre illustratif ;
- la figure 7 illustre à titre d'exemple un profil temporel d'une densité de puissance transférée à la couche, pendant une impulsion lumineuse ;
- la figure 8 illustre des pics d'intensité de rayons X obtenus pour des orientations θ variables dans l'analyse d'une couche de CIS électrodéposée (courbe en traits pleins) et traitée par recuit rapide (courbe en traits pointillées).

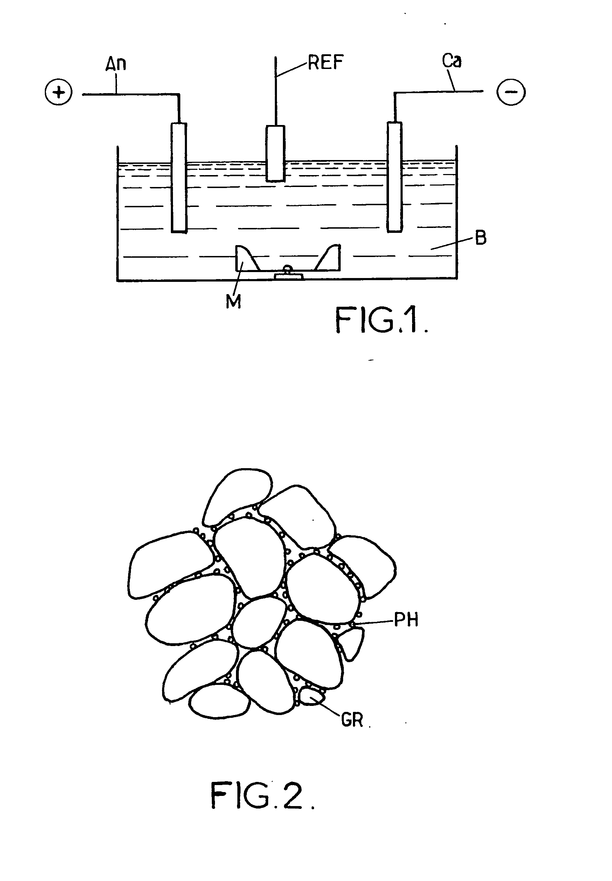

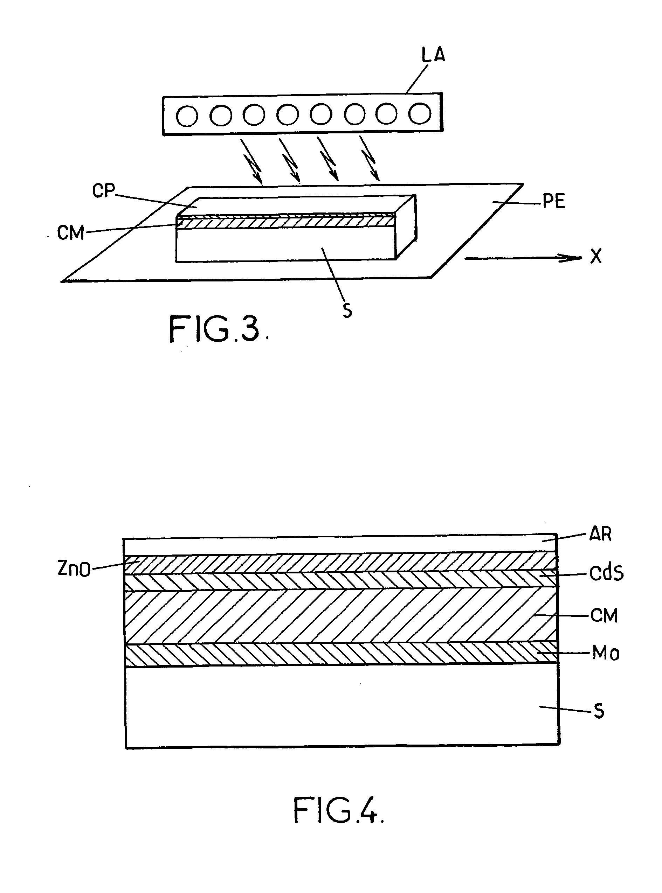

En se référant à la figure 1, des couches minces (ou "*films*") de diséléniure de cuivre et d'indium sont obtenues à pression et température ambiante par électrodéposition d'un film précurseur CM sur un substrat de verre S, recouvert de molybdène Mo au préalable (figure 4). Avantageusement, le substrat S est initialement recouvert d'une couche supplémentaire, conductrice, électronique, par exemple métallique ou sous forme d'oxyde (non représentée). Cette couche conductrice peut en outre reposer sur une ou plusieurs sous-couches servant à une application spécifique (barrière de diffusion, miroir ou autre) dans la fabrication de cellules photovoltaïques.

En se référant à la figure 1, l'électrodéposition est effectuée dans un bain B contenant un sel d'indium, un sel de cuivre et de l'oxyde de sélénium dissout.

Les sels sont mélangés pendant le dépôt grâce à un agitateur tournant M immergé dans le bac d'électrochimie B.

Ainsi, la couche mince est obtenue par électrodéposition d'un précurseur dont les éléments constitutifs sont intimement pré-mélangés.

Selon des exemples plus générales que l'invention revendiquée, les paramètres du dépôt peuvent être choisis dans des plages suivantes :

Les concentrations des éléments du précurseur (sous forme de sels et d'oxyde dans la solution) sont comprises entre 10⁻⁴ et 10⁻¹ mol/l. Préférentiellement, le pH de la solution est fixé entre 1 et 3. Le potentiel appliqué à l'électrode de molybdène (cathode Ca) est compris entre -0,8 volt et -1,9 volt par rapport à l'électrode de référence REF, ici au sulfate mercureux.

Des dépôts de couches minces d'épaisseur comprise entre 0,1 et 3 µm sont obtenus, avec des densités de courant d'environ 0,5 à 4 mA/cm².

Selon l'invention, un dépôt de précurseur est réalisé à partir d'un bain dont les concentrations sont les suivantes : [Cu(SO₄)]= 1,0.10⁻³ mol/l, [In₂(SO₄)₃]= 6,0.10⁻³ mol/l, [H₂SeO₃]= 1,7.10⁻³ mol/l, [Na₂(SO₄)]= 0,1 mol/l.

Le pH du bain est de 2. Les précurseurs sont déposés par réaction cathodique à potentiel imposé, de -1 volt par rapport à l'électrode de référence au sulfate mercureux. La densité de courant est de -1 mA/cm².

Dans la mesure où les sels de cuivre et d'indium, ainsi que l'oxyde de sélénium dissout, sont mélangés dans la solution du bain B, à la fin de l'étape a) précitée d'électrodéposition, on obtient un précurseur dont les éléments sont intimement pré-mélangés.

Le film de précurseur obtenu est dense, adhérent, de morphologie homogène et sa composition est proche de la composition stoechiométrique Cu (25%), In (25%), Se (50%).

Le tableau ci-après indique la composition atomique en pourcentage, en différents points (points 1 à 5) d'un film de précurseur CIS électrodéposé sur un substrat d'environ 10 cm², ces compositions ayant été analysées par microsonde électronique (WDX).

| | **Cu (% atom.)** | **In (% atom.)** | **Se (% atom.)** | **In/Cu** | **Se/(In+Cu)** |
|---|---|---|---|---|---|
| **Point 1** | 22.5 | 24,3 | 53,3 | 1,080 | 1.14 |
| **Point 2** | 22,7 | 24,4 | 52.9 | 1,075 | 1,12 |
| **Point 3** | 22.6 | 24,6 | 52,8 | 1,088 | 1.12 |
| **Point 4** | 22,9 | 24,5 | 52,6 | 1,070 | 1,11 |
| **Point 5** | 22.9 | 24.3 | 52.8 | 1.061 | 1,12 |
| **Moyenne** | 22,72 | 24,42 | 52,88 | 1,075 | 1,122 |
| **Ecart**-**type** | 0,179 | 0,130 | 0,259 | 0,010 | 0,011 |

En se référant à la colonne relative à la composition en sélénium Se, on constate néanmoins un léger excès en sélénium par rapport à la quantité nécessaire pour s'associer au cuivre sous forme de Cu₂Se et à l'indium sous forme de In₂Se₃. Dans l'exemple décrit, cet excès de sélénium est d'environ 10%.

L'excès en sélénium est un élément favorable à l'obtention d'un caractère semi-conducteur de type p de la couche après l'étape de recuit, permettant une conversion photovoltaïque satisfaisante.

De même, on constate un léger excès en indium, par rapport au cuivre, d'environ 7%. Cet excès d'indium est apparu aussi comme jouant un rôle favorable pour l'obtention des propriétés photovoltaïques.

On peut vérifier que le dépôt respecte une uniformité satisfaisante en composition dans le plan de la couche mince. De plus, les Demandeurs ont constaté que cette uniformité était aussi respectée en épaisseur de couche, notamment en procédant à des analyses fines de type SIMS ("*Secondary Ion Mass Spectroscopy*") ou EELS ("*Electron Energy Loss Spectroscopy*").

Toutefois, il est aussi possible de créer un gradient de composition dans la couche déposée, par exemple en faisant varier la proportion de composition en cuivre en fonction de l'épaisseur (notamment en jouant sur la valeur du potentiel électrochimique imposé pendant l'électrodéposition). Un tel gradient de composition permet avantageusement d'obtenir un confinement des porteurs dans les applications photovoltaïques visées.

De telles analyses fines (SIMS, EELS) on montré en outre que la composition du précurseur électrodéposé est majoritairement voisine de celle désirée pour l'alliage final, dans des grains GR de quelques dizaines de nanomètres, représentés à titre illustratif sur la figure 2. Dans la composition finale de l'alliage obtenu après l'étape de recuit rapide, l'excédent en sélénium est bien inférieur à l'ordre de 1%, mais est suffisant pour "*doper*" (comme un dopage de type p à environ 10¹⁶ cm⁻³) le CIS recuit. On comprendra donc que la composition de l'alliage obtenu après recuit est très proche de celle de l'alliage stoechiométrique I-III-VI₂. C'est sensiblement cette composition qui est essentiellement présente dans les grains GR du précurseur électrodéposé, avant recuit.

En se référant à la figure 2, les films obtenus après l'étape d'électrodéposition sont constitués d'une matrice globalement amorphe (ou peu cristallisée par rapport à l'alliage après recuit) mais comprenant majoritairement des grains GR de CIS (cristallites de l'ordre de quelques dizaines de nanomètres).

On entend par le terme "*matrice*" une nature composite de la couche susceptible de présenter plusieurs phases possibles : ternaire (dans le cas du CIS), binaire (par exemple CuₓSe avec x voisin de 2 et InₓSe_{y} avec x voisin de 2 et y voisin de 3), ou même élémentaire (sélénium ou autre). Comme indiqué ci-avant, les grains GR sont de composition proche de celle désirée pour l'alliage final, par exemple CuInSe₂ dans le cas du CIS, alors que globalement le précurseur présente un excès de sélénium d'environ 10%. On constate ainsi qu'en dehors des grains ou à la superficie des grains tels que représentés sur la figure 2 à titre d'exemple, des phases PH plus riches en sélénium sont présentes, par exemple du sélénium élémentaire Se ou du binaire CuSe.

Le volume de la couche occupé par les grains GR est néanmoins largement prépondérant par rapport à celui occupé par ces phases PH. Le précurseur ainsi électrodéposé présente globalement une nature physico-chimique majoritairement proche de celle de l'alliage final désiré, et ce, non seulement en terme de composition mais aussi en terme de liaisons chimiques, qui sont celles de l'alliage désiré dans les grains GR. Ainsi, le mélange intime des éléments (donc les faibles distances de migration des éléments durant le recuit) contribue à ce que l'alliage ne se dégrade pas pendant le recuit.

Outre les grains majoritaires de CIS, des grains de binaires de compositions voisines de Cu₂Se et In₂Se₃ (non représentés sur la figure 2) peuvent aussi coexister localement. Ces grains, pendant l'étape b) de recuit rapide, sont capables aussi de réagir ensemble pour donner un plus gros grain cristallisé de composition proche de CuInSe₂.

Même si les risques d'exodiffusion pendant le recuit rapide sont limités, on dépose en outre, avant l'étape de recuit, une couche recouvrant la couche de précurseur pour limiter encore une exodiffusion d'éléments du précurseur, tels que Se, pendant l'étape de recuit.

Le bon degré d'oxydation des éléments ainsi mélangés pendant l'étape d'électrodépôt évite des réactions chimiques incontrôlées pendant le recuit. En d'autres termes, l'énergie libre de réaction est relativement faible, ce qui évite l'apparition de réactions fortement exothermique, comme celles de l'indium et du sélénium élémentaires dans le CIS. En effet, les éléments In et Se sous forme élémentaire In⁰, Se⁰ sont très réactifs. Dans un procédé de dépôt dit "*en feuillets*" tel que décrit ci-avant, un recuit trop rapide pourrait mener à une dégradation de la couche, notamment pour cette raison.

En outre, cette matrice est sensiblement homogène dans la répartition spatiale de son coefficient de dilatation. Elle est donc capable de supporter une augmentation brusque en température pendant l'étape de recuit par éclairement, en comparaison de la structure hétérogène, en feuillets, précitée.

De façon plus générale, la nature physico-chimique (degré d'oxydation, densité, coefficient de dilatation en température) du précurseur est majoritairement très proche de la phase cristallisée CuInSe₂, ce qui limite fortement la création d'inhomogénéités pendant le recuit (gonflements, décollements localisés). Ainsi, on comprendra que la matrice obtenue après l'étape d'électrodéposition et comprenant les éléments du précurseur pré-mélangés permet avantageusement d'effectuer un recuit rapide, cette matrice étant capable de supporter des puissances transférées supérieures ou égales à 10W/cm².

Les films de précurseur après l'étape de dépôt ne possèdent que de faibles propriétés photovoltaïques en l'état. En fait, ces propriétés photovoltaïques sont obtenues seulement après un traitement par recuit thermique. La recristallisation de la couche mince permet d'obtenir de bonnes propriétés de transfert de charge pour la conversion photovoltaïque.

Selon l'une des caractéristiques de l'invention, ce traitement thermique est effectué à partir d'un recuit rapide de la couche mince CM électrodéposée. En se référant à la figure 3, la couche mince CM électrodéposée sur le substrat S est disposée sur un porte-échantillon PE qui est, de préférence, capable de se déplacer dans un plan horizontal (déplacement le long de l'axe X, tel que représenté sur la figure 3), relativement à une source de lumière LA qui, dans l'exemple décrit, est une rampe de lampes halogènes à forte puissance de rayonnement, avantageusement dans une bande d'absorption optique de la couche mince CM. Ainsi, on entend, dans l'exemple décrit, par *"recuit rapide"* un éclairement du film CM de manière à permettre une cristallisation au moins partielle de cette couche mince, pendant des durées totales de l'ordre de la dizaine de secondes. Ce recuit rapide est effectué dans un four à lampe (figure 3) dans lequel la couche mince peut recevoir par incidence directe des puissances rayonnées de l'ordre de 10W/cm² et plus. En variante, on peut prévoir un recuit rapide par chauffage à induction à partir d'une boucle de courant.

L'énergie transférée à la couche mince pendant le recuit rapide rend le sélénium actif (le sélénium étant en particulier excédentaire à l'extérieur des grains GR), ce qui amorce une agglomération des grains GR comme par frittage. Les grains GR, nanométriques dans le précurseur, se joignent en formant de plus gros grains, de taille sensiblement micrométrique. Le sélénium en excès joue, pendant le recuit rapide, un rôle important d'agent de recristallisation et de passivation des défauts. Ce rôle est favorisé notamment par les faibles distances interatomiques qu'a le sélénium à parcourir. La structure en matrice homogène du précurseur joue quant à elle, pendant le recuit, un rôle de "*couvercle interne"* pour le sélénium (par confinement) en limitant fortement son exodiffusion.

Avantageusement, les recuits peuvent être effectués sous pression atmosphérique, à l'air ambiant, ou encore sous pression de gaz neutre (par exemple argon ou azote).

Dans l'exemple décrit, la puissance maximale par unité de surface que reçoit effectivement la couche mince est estimée à 25 W/cm², en tenant compte de la puissance nominale des lampes, de la dispersion de la lumière entre les lampes et la couche mince, des pertes par réflexion, et autres.

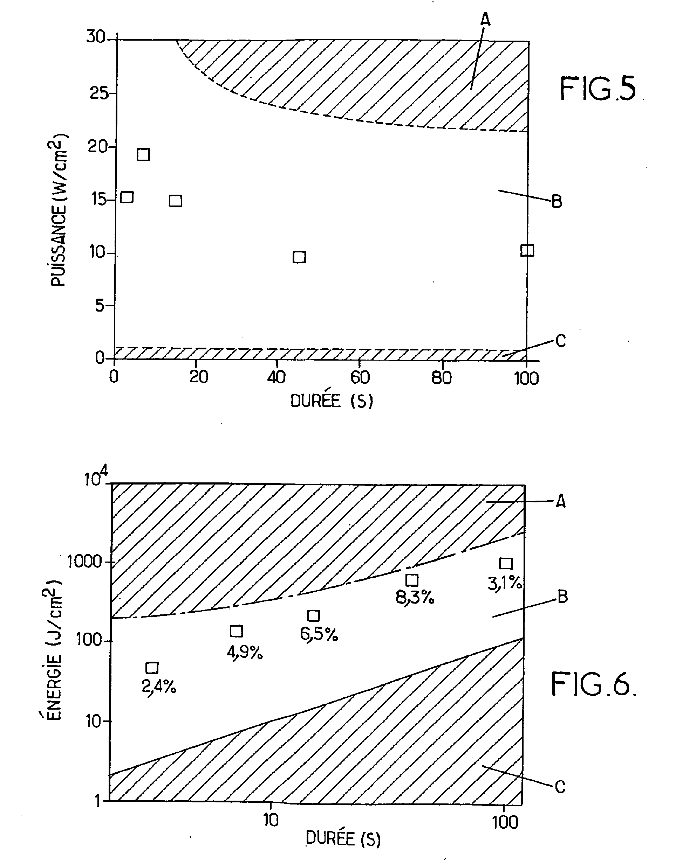

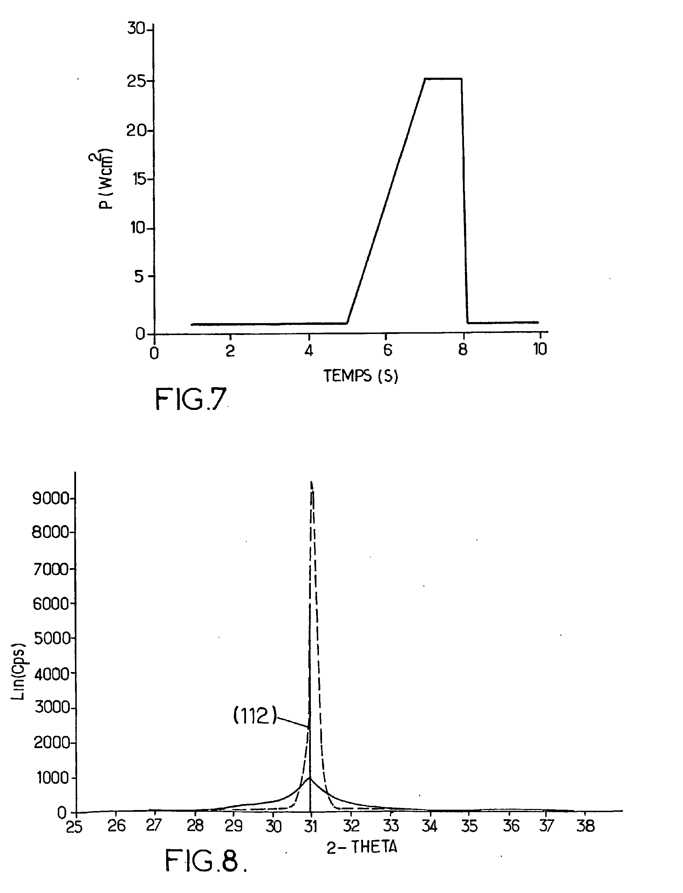

La figure 7 représente une impulsion à une puissance maximale, commandée pour 3 secondes. On constate cependant des fronts de montée et de descente de la puissance lumineuse délivrée en fonction du temps, dus à l'inertie des lampes. Néanmoins, en se référant maintenant à la figure 5, une telle impulsion a permis toutefois de recuire une couche mince de CIS en la cristallisant de façon satisfaisante de manière à obtenir de bonnes propriétés photovoltaïques.

La figure 5 représente des points expérimentaux (carrés foncés) correspondant à des couples puissance lumineuse moyenne/durée de recuit qui ont permis d'obtenir des couches cristallisées. L'impulsion précitée de 3 secondes correspond au premier point à gauche du graphique. Les zones A, B et C, délimitées par des courbes en traits pointillés, correspondent respectivement à :
- des couples puissance/durée pour lesquels la puissance est trop importante (zone A) et la couche est susceptible d'être dégradée pendant le recuit,
- des couples puissance/durée permettant d'obtenir une cristallisation satisfaisante de la couche (zone B), et
- des couples puissance/durée pour lesquels la puissance n'est pas suffisante pour recuire correctement la couche (zone C).

Ainsi, le domaine d'exploitation du recuit (zone B) en termes de couple "*puissance*/*durée*" est délimité par une courbe de cristallisation (zone inférieure en puissance) et une courbe de dégradation du film (zone supérieure en puissance). A fortes puissances, les Demandeurs ont constaté parfois une dégradation des films, notamment de la couche de molybdène sous-jacente. A des puissances trop faibles et/ou des temps trop longs, la cristallisation est insuffisante et une évaporation du sélénium risque simplement de se produire, la tension de vapeur saturante du sélénium étant déjà significative à 200°C.

Un point expérimental de la figure 5 (hormis le premier point précité) peut correspondre à une ou plusieurs impulsions lumineuses successives, séparées par des périodes sans éclairement. Une représentation plus exactes de ces points expérimentaux apparaît sur la figure 6, montrant des couples "*énergie fournie*/*durée*", à des échelles logarithmiques en abscisses et en ordonnées. Les domaines sont délimités par des courbes sensiblement linéaires avec de telles échelles.

Bien entendu, ces domaines sont représentés sur les figures 5 et 6 à titre d'illustration : ils ne servent qu'à la compréhension des phénomènes en jeu.

Néanmoins, les Demandeurs ont constaté que, pour une épaisseur de couche voisine du micromètre déposée sur un substrat en verre, la puissance transférée à la couche devait être supérieure à quelques Watts par cm² pour commencer une cristallisation satisfaisante. Un recuit avantageux est obtenu pour une puissance supérieure à 15 W/cm², pendant une durée inférieure à quelques dizaines de secondes.

La couche mince CM, après recuit, est avantageusement recristallisée de façon sensiblement équivalente, voire meilleure, par rapport à ce qui est obtenu à l'issue des recuits classiques, sous pression de vapeur de sélénium, à des températures supérieures à 450° C et pendant des durées voisines d'une heure.

Ainsi, selon l'un des avantages que procure la présente invention, la structure pré-mélangée du précurseur électrodéposé est de nature à favoriser le processus de recristallisation, cependant avec des durées bien inférieures à celles des recuits classiques.

En particulier, la structure pré-mélangée obtenue après l'étape d'électrodéposition permet une cristallisation plus rapide et plus contrôlable, par rapport au procédé décrit ci-avant de dépôt par pulvérisation de couches minces selon la structure dite "*en feuillets*". En effet, la matrice de précurseurs électrolysée obtenue après l'étape de dépôt comprend des constituants intimement mélangés à l'échelle atomique, ces constituants n'ayant pas besoin de diffuser sur de grandes longueurs (par rapport aux distances inter-atomiques) pour former la phase CuInSe₂ pendant le recuit.

Par ailleurs, dans les procédés classiques, la quantité de sélénium en excès est habituellement beaucoup plus importante que 10% après l'étape de dépôt et avant le recuit, ce qui grève le coût d'obtention de bons matériaux photovoltaïques. Comme indiqué ci-avant, une autre solution de l'état de la technique consiste en une sélénisation en présence du gaz H₂Se. Cependant, ce gaz est très réactif et très toxique. Ainsi, avec le procédé objet de la présente invention, on obtient des performances photovoltaïques avec, néanmoins, des quantités initiales relativement faibles de sélénium directement après le dépôt par électrochimie et sans ajout de sélénium pendant le recuit. En effet, les cinétiques rapides pendant le recuit limitent fortement l'exodiffusion de l'élément Se hors de la couche. Cet effet permet avantageusement de s'affranchir de l'utilisation habituelle qui est faite du gaz toxique H₂Se dans les procédés de sélénisation, ainsi que de tout autre apport de Se pendant l'étape de recuit.

Toutefois, l'utilisation d'un recuit rapide au sens de la présente invention est également compatible avec l'apport d'éléments VI (par exemple de sélénium ou de soufre pour augmenter la largeur de bande interdite du semi-conducteur), pendant la phase de cristallisation.

Selon un autre avantage que procure la présente invention, le temps relativement court de recuit permet de limiter les risques de déformation du substrat S due à des températures trop élevées. Ce substrat peut être en verre mais aussi dans tout autre matériau supportant de moindres élévations en température. En effet, la combinaison d'un dépôt en solution (par électrochimie ou par précipitation), à température ambiante, et d'un recuit rapide permet une recristallisation des films sans que le substrat ait le temps d'être altéré de manière préjudiciable à l'application visée. Ainsi, des dépôts sur substrats déformables (par exemple en matière plastique) peuvent être prévus. Avantageusement, un dépôt sur substrat en polymère tel que du KAPTON^{®} peut être recuit à partir d'une ou de plusieurs impulsions d'une puissance d'éclairement voisine de 25 W/cm² et de quelques secondes. En outre, des résultats satisfaisants ont été aussi obtenus pour du CIS électrodéposé sur un substrat métallique, tel qu'une feuille d'aluminium. Les Demandeurs ont alors constaté que le substrat métallique supporte avantageusement le recuit rapide permettant une recristallisation satisfaisante du CIS. Un dépôt par électrochimie sur un substrat métallique, conducteur, permet avantageusement de s'affranchir de la couche de molybdène sous-jacente. Par ailleurs, le dépôt sur un substrat souple (tel qu'une feuille d'aluminium ou un panneau de KAPTON) permet avantageusement de produire des matériels pour des applications photovoltaïques qui peuvent être embarqués dans des aéronefs spatiaux, en raison de leur légèreté et de leur capacité de pliage.

La figure 8 représente un diagramme de diffraction des rayons X d'un film de CIS avant et après recuit rapide (respectivement courbe en trait plein et en traits pointillés). Avant recuit, la raie selon le plan (112), caractéristique du CIS, est très large et peu intense, ce qui montre que le précurseur électrodéposé est mal cristallisé. Néanmoins, la phase ternaire du CIS apparaît ici majoritairement, alors que les phases de binaires ou les phases élémentaires (par exemple Cu) n'apparaissent pratiquement pas. On remarque ainsi essentiellement une superposition des raies de diffraction selon le plan (112) du CIS avant et après recuit. Cependant, après recuit, la raie (112) est plus fine et intense.

Après recuit rapide de la couche CM, des cellules photovoltaïques sont réalisées en déposant une fine couche de CdS puis d'une couche de ZnO par pulvérisation cathodique (figure 4). Le cas échéant, il peut être prévu une dernière couche ou un empilement anti-reflet AR, de manière augmenter le rendement de la cellule solaire. Les cellules ainsi réalisées présentent des propriétés photovoltaïques conduisant à des rendements de l'ordre de 8% (figure 6), sans gallium et sans la couche anti-reflet AR représentée sur la figure 4.

Ainsi, la combinaison d'un dépôt par électrochimie, d'éléments de précurseur pré-mélangés et d'un recuit rapide de la couche de précurseur constitue un procédé plus rapide, à moindre coût (puisque les sels présents dans le bain B peuvent être utilisés dans une électrolyse ultérieure) et non polluant (en s'affranchissant ainsi des émanations toxiques de H₂Se). De plus, l'étape de dépôt a lieu à température et à pression ambiantes (respectivement 20° C environ et 1 atm). Comme indiqué en référence au tableau ci-avant, ce procédé offre la possibilité de traiter de grandes surfaces, avec une bonne uniformité.

## Revendications

1. Procédé de fabrication en couches minces d'alliages semi-conducteurs I-III-VI₂, pour des applications photovoltaïques, dans lequel :
a) on dépose par électrochimie, sur un substrat, une couche mince d'un précurseur de composition excédentaire en élément VI par rapport à la somme de la composition en élément I et en élément III, d'environ 10% par rapport à la composition d'alliage finale I-III-VI₂, tout en mélangeant les éléments constitutifs du précurseur, l'élément I étant le cuivre, l'élément III étant l'indium et l'élément VI étant le sélénium, l'indium étant en excès, par rapport au cuivre, d'environ 7%, l'excès de sélénium étant d'environ 10%, le dépôt de précurseur étant réalisé à partir d'un bain dont les concentrations sont les suivantes : [Cu(SO₄)] =1,0.10⁻³ mol/l, [In₂(SO₄)₂]=6,0.10⁻³ mol/1, [H₂SeO₃]=1,7.10⁻³ mol/l, [Na₂(SO₄)]=0,1 mol/l, le ph du bain étant de 2, le précurseur étant déposé par réaction cathodique à potentiel imposé de -1 Volt par rapport à une électrode de référence au sulfate mercureux, et une densité de courant de -1 mA/cm², de manière à conférer au précurseur une structure comportant des grains nanométriques d'alliages de composition I-III-VI₂, joints par des phases plus riches en élément VI que la composition I-III-VI₂, et
b) on effectue, à partir d'une source de rayonnement électromagnétique, un recuit de la couche obtenue à l'étape a),
avec une puissance électromagnétique supérieure à 10 W/cm², suffisante pour activer l'élément VI et faire réagir ensemble lesdits grains d'alliages, de manière à améliorer la cristallisation de ladite couche, et
pendant une durée inférieure à 30 secondes, suffisamment courte pour limiter l'exodiffusion de l'élément VI et obtenir sensiblement ladite composition I-III-VI₂ dans la couche et conférer à ladite couche des propriétés photovoltaïques.

2. Procédé selon la revendication 1, dans lequel lesdits grains d'alliages sont de nature physico-chimique proche de celle de l'alliage obtenu à l'étape b), et forment ensemble une matrice capable de supporter une augmentation en température supérieure à 450°C pendant ladite durée de l'étape de recuit b).

3. Procédé selon l'une des revendications précédentes, dans lequel la température de la couche est élevée à plus de 450°C à l'étape b).

4. Procédé selon l'une des revendications précédentes, dans lequel la puissance transférée à la couche est de l'ordre de 20 W/cm², pendant une durée inférieure à 10 secondes.

5. Procédé selon l'une des revendications précédentes, dans lequel le substrat est réalisé dans une matière plastique.

6. Procédé selon l'une des revendications précédentes, dans lequel le substrat est réalisé dans un matériau métallique, préférentiellement en aluminium.

7. Procédé selon l'une des revendications précédentes, dans lequel on dépose en outre à l'étape a) une couche protectrice recouvrant la couche d'alliage et propre à limiter une exodiffusion d'élément VI hors de la couche d'alliage pendant l'étape de recuit b).

8. Procédé selon la revendication 7, dans lequel ladite couche protectrice est soluble au moins après l'étape de recuit b).

## Patentansprüche

1. Verfahren zur Herstellung von Dünnschicht-Halbleiterlegierungen I-III-Vl₂ für photovoltaische Anwendungen, wobei:
a) auf einem Substrat eine Dünnschicht eines Precursors elektrochemisch abgeschieden wird, wobei die Zusammensetzung des Precursors einen Überschuss an Element VI bezüglich der Summe aus dem Element I und dem Element III von ungefähr 10% bezüglich der Legierungsendzusammensetzung I-III-Vl₂ aufweist, wobei die den Precursor bildenden Elemente miteinander vermischt werden, wobei das Element I Kupfer, das Element III Indium und das Element VI Selen ist, wobei das Indium bezüglich des Kupfers um 7 % im Überschuss ist, wobei der Überschuss von Selen ungefähr 10 % beträgt, wobei die Abscheidung des Precursors ausgehend von einem Bad erfolgt, in dem die Konzentrationen wie folgt sind: [Cu(SO₄)] = 1,1*10⁻³ mol/l, [In₂(SO₄)₃] = 6,0*10⁻³ mol/l, [H₂SeO₃] = 1,7*10⁻³ mol/l, [Na₂(SO₄)] = 0,1 mol/l, wobei der pH-Wert des Bades 2 ist, wobei der Precursor durch Kathodenreaktion bei einem Potential von -1 Volt bezüglich einer Quecksilbersulfat-Referenzelektrode abgeschieden wird, und wobei die Stromdichte -1 mA/cm² beträgt, so dass dem Precursor eine Struktur verliehen wird, die nanometrische Legierungskörner der Zusammensetzung I-III-Vl₂ umfasst, die durch Phasen, die das Element VI in größerer Menge als die Verbindung I-III-Vl₂ aufweisen, verbunden sind, und
b) mittels einer elektromagnetischen Strahlungsquelle die in Schritt a) erhaltene Schicht getempert wird,
mit einer elektromagnetischen Leistung, die höher als 10 W/cm² ist, was ausreicht, um das Element VI zu aktivieren und die Legierungskörner miteinander reagieren zu lassen, um die Kristallisation der Schicht zu verbessern, und
während einer Dauer kürzer als 30 Sekunden, was kurz genug ist, um die Exodiffusion des Elements VI zu beschränken und im Wesentlichen die Zusammensetzung I-III-Vl₂ in der Schicht zu erhalten und der Schicht photovoltaische Eigenschaften zu verleihen.

2. Verfahren nach Anspruch 1, **dadurch gekennzeichnet, dass** die Legierungskörner in physiko-chemischer Hinsicht der Legierung, die in Schritt b) erhalten wird, sehr ähnlich sind und zusammen einen Matrix bilden, die geeignet ist, eine Temperaturerhöhung oberhalb 450 °C während der Dauer des Temperschritts b) zu vertragen.

3. Verfahren nach einem der vorherigen Ansprüche, **dadurch gekennzeichnet, dass** die Temperatur der Schicht in Schritt b) auf oberhalb 450° C angehoben wird.

4. Verfahren nach einem der vorherigen Ansprüche, **dadurch gekennzeichnet, dass** die an die Schicht übertragene Leistung in der Größenordnung von 20 W/cm² während einer Dauer von weniger als 10 Sekunden liegt.

5. Verfahren nach einem der vorherigen Ansprüche, **dadurch gekennzeichnet, dass** das Substrat in einem Kunststoff ausgebildet ist.

6. Verfahren nach einem der vorherigen Ansprüche, **dadurch gekennzeichnet, dass** das Substrat in einem Metall, vorzugsweise in Aluminium, ausgebildet ist.

7. Verfahren nach einem der vorherigen Ansprüche, **dadurch gekennzeichnet, dass** in Schritt a) ferner eine Schutzschicht abgeschieden wird, die die Legierungsschicht abdeckt und ausgebildet ist, um eine Exodiffusion des Elements VI außerhalb der Legierungsschicht während des Temperschrittes b) zu begrenzen.

8. Verfahren nach Anspruch 7, **dadurch gekennzeichnet, dass** die Schutzschicht zumindest nach dem Temperschritt b) löslich ist.

## Claims

1. Method of manufacturing I-III-VI₂ semiconductor alloys in thin layers for photovoltaic applications, wherein:
a) a thin layer of a precursor composition with an excess of element VI compared with the sum of the composition of element I and element III, namely approximately 10% compared with the final I-III-VI₂ alloy composition, is electrochemically deposited on a substrate whilst mixing the elements constituting the precursor, element I being copper, element III being indium and element VI being selenium, there being an excess of indium of approximately 7% compared with copper, the excess of selenium being of approximately 10%, and the precursor is deposited from a bath, the concentrations of which are as follows: [Cu(SO₄)] = 1.0.10⁻³ mol/l, [In2(SO4)3] = 6.0.10⁻³ mol/l, [H₂SeO₃] = 1.7.10⁻³ mol/l, [Na₂(SO₄)] = 0.1 mol/l, the pH of the bath being 2, the precursor being deposited by cathodic reaction at an applied potential of -1 volt relative to a reference electrode of mercury sulphate and a current density of -1 mA/cm², so as to impart to the precursor a structure having nanometric alloy grains of a I-III-VI₂ composition joined by phases that are richer in element VI than the I-III-VI₂ composition, and
b) the layer obtained in step a) is annealed using an electromagnetic radiation source,
with an electromagnetic power in excess of 10 W/cm², this being sufficient to activate the VI element and cause all of said alloy grains to react, in order to improve the crystallisation of said layer, and
for a duration of less than 30 seconds, this being short enough to limit exodiffusion of the VI element and obtain essentially said I-III-VI₂ composition in the layer and impart photovoltaic properties to said layer.

2. Method as claimed in claim 1, wherein said alloy grains are of a physico-chemical nature close to that of the alloy obtained in step b) and together form a matrix capable of withstanding an increase in temperature greater than 450°C throughout said duration of the annealing step b).

3. Method as claimed in one of the preceding claims, wherein the temperature of the layer is raised to more than 450°C in step b).

4. Method as claimed in one of the preceding claims, wherein the power transmitted to the layer is in the order of 20 W/cm² for a duration of less than 10 seconds.

5. Method as claimed in one of the preceding claims, wherein the substrate is made from a plastic material.

6. Method as claimed in one of the preceding claims, wherein the substrate is made from a metal material, preferably aluminium.

7. Method as claimed in one of the receding claims, wherein a protective layer covering the alloy layer and capable of limiting exodiffusion of the VI element from the alloy layer during annealing step b) is also deposited during step a) .

8. Method as claimed in claim 7, wherein said protective layer is soluble at least after annealing step b).
